# EUROPEAN PATENT APPLICATION

(11) **EP 4 047 641 A2**
(43) Date of publication of application: **24.08.2022**
(21) Application number: 22151582.8
(22) Date of filing: 14.01.2022
(51) Int. Cl.: H01L 21/603, H01L 21/98, H01L 23/488

(54) **METHOD FOR PRODUCING A SEMICONDUCTOR DEVICE BY CONSECUTIVELY SINTER-BONDING A PLURALITY OF SEMICONDUCTOR CHIPS TO A SUBSTRATE UPON APPLICATION OF PRESSURE AND HEAT AND CORRESPONDING SEMICONDUCTOR DEVICE**

(30) Priority: 18.01.2021 JP 2021005659; 11.10.2021 JP 2021166838
(71) Applicant: NITTO DENKO CORPORATION, Ibaraki-shi Osaka 567-8680 (JP)
(72) Inventor: SATO, Mayu, Osaka, 567-8680 (JP); ICHIKAWA, Tomoaki, Osaka, 567-8680 (JP); MITA, Ryota, Osaka, 567-8680 (JP)
(74) Representative: Stolmár & Partner Patentanwälte PartG mbB

(57) **Abstract**

A method for producing a semiconductor device includes a semiconductor chip mounting step of subsequently pressing a plurality of semiconductor chips (B1, B2) by a first pressing member (A) (e.g., a collet) to respectively bond the plurality of semiconductor chips (B1, B2) to a plurality of mounting areas (E1, E2) (e.g., die pads) provided on a substrate (D) (e.g., a lead frame), wherein the bonding is performed in a state where adhesive sheets (2) are respectively interposed between the plurality of semiconductor chips (B1, B2) and the plurality of mounting areas (E1, E2), wherein each of the adhesive sheets (2) includes sinterable metal particles that can be sintered by heating at a temperature of 400 °C or less, and the first pressing member (A) is heated to a temperature at which the sinterable metal particles can be sintered, for example, to a temperature of 250 °C or more, thereby subjecting the sinterable metal particles in the adhesive sheet (2) to a primary sintering. The substrate (D) may be mounted on a stage (H), and the primary sintering may be performed by heating the stage (H), in addition to the collet (A), to a temperature equal to or higher than the temperature at which the sinterable metal particles can be sintered. The method may further comprise performing, after the semiconductor chip mounting step, a secondary heating step of heating the substrate (D) with the plurality of semiconductor chips (B1, B2) mounted thereon to a temperature at which the sinterable metal particles can be sintered, thereby performing a secondary sintering, wherein, in the secondary heating step, the heating is performed while not pressing part or all of the plurality of semiconductor chips (B1, B2) onto the substrate (D) or, alternatively, while pressing part or all of the plurality of semiconductor chips (B1, B2) onto the substrate (D), for example, using a heating and pressing device (F) that includes two parallel flat plates configured to apply heat and located so as to sandwich, from above and below, part or all of the semiconductor chips (B1, B2) mounted on the mounting areas (E1, E2) of the substrate (D). The semiconductor device produced by this method is such that a shear strength between one of the plurality of semiconductor chips (B1, B2) and a corresponding one of the plurality of mounting areas (E1, E2) at 25 °C is 2 MPa or more.

## Description

### CROSS-REFERENCE TO RELATED APPLICATION

This application claims priority to Japanese Patent Application No. 2021-005659 and Japanese Patent Application No. 2021-166838, the disclosures of which are incorporated herein by reference in its entirety.

### FIELD OF THE INVENTION

The present invention relates to a semiconductor device and a method for producing a semiconductor device.

### BACKGROUND OF THE INVENTION

There is a conventionally known method for bonding a semiconductor chip (hereinafter also referred to as a die) to a substrate (e.g., a lead frame substrate) with a film including sinterable particles interposed therebetween (for example, JP 2014-503936 T).

JP 2014-503936 T describes that a dried film is formed using a pasty composition including sinterable particles (hereinafter also referred to as a sheet), and the die is bonded to the substrate through the film. JP 2014-503936 T also describes that at least one die is disposed on the substrate with the film interposed therebetween to form an assembly, followed by applying a temperature of 175 °C to 400 °C to the assembly, while applying a pressure of less than 40 MPa to the assembly, to mount the at least one die on the substrate.

### SUMMARY OF THE INVENTION

### Technical Problem

Meanwhile, when a plurality of semiconductor chips having the above configuration are mounted on the substrate at a time according to the method described in JP 2014-503936 T by simultaneous applications of heat and pressure in a state a sheet including sinterable particles is interposed between the semiconductor chips and the substrate, unevenness in the adhered state of the plurality of semiconductor chips to the substrate, or uneven adhesion is sometimes caused. However, it is hard to say that sufficient study has been made on suppression of the uneven adhesion in mounting the plurality of semiconductor chips to the substrate with the sheet (i.e., adhesive sheet) interposed therebetween.

Therefore, it is an object of the present invention to provide a method for producing a semiconductor device that can comparatively suppress uneven adhesion in mounting a plurality of semiconductor chips to a substrate with an adhesive sheet interposed therebetween, and a semiconductor device produced by the method.

### Solution to Problem

According to the present invention, there is provided a method for producing a semiconductor device, the method includes: a semiconductor chip-mounting step of subsequently pressing a plurality of semiconductor chips by a first pressing member to respectively bond the plurality of semiconductor chips to a plurality of mounting areas provided on a substrate, wherein the bonding is performed in a state where adhesive sheets are respectively interposed between the plurality of semiconductor chips and the plurality of mounting areas, each of the adhesive sheets includes sinterable metal particles that can be sintered by heating at a temperature of 400 °C or less, and the first pressing member is heated to a temperature, at which the sinterable metal particles can be sintered.

The method for producing the semiconductor device preferably further includes: performing, after the semiconductor chip-mounting step, a secondary heating step of heating the substrate with the plurality of semiconductor chips mounted thereon to a temperature, at which the sinterable metal particles can be sintered, wherein in the secondary heating step, the aforementioned heating is performed while not pressing part or all of the plurality of semiconductor chips onto the substrate.

The method for producing the semiconductor device is preferably configured such that in the secondary heating step, the aforementioned heating is performed while not pressing all of the plurality of semiconductor chips onto the substrate.

The method for producing the semiconductor device preferably further includes: performing, after the semiconductor chip-mounting step, a secondary heating step of heating the substrate with the plurality of semiconductor chips mounted thereon to a temperature, at which the sinterable metal particles can be sintered, wherein in the secondary heating step, the aforementioned heating is performed while pressing part or all of the plurality of semiconductor chips onto the substrate.

The method for producing the semiconductor device is preferably configured such that in the secondary heating step, the aforementioned heating is performed while pressing all of the plurality of semiconductor chips onto the substrate.

The method for producing the semiconductor device is preferably configured such that in the semiconductor chip-mounting step, the first pressing member is heated to a temperature of 250 °C or more.

According to the present invention, there is further provided a semiconductor produced by any one of the aforementioned methods for producing the semiconductor device, wherein a shear strength between one of the plurality of semiconductor chips and a corresponding one of the plurality of mounting areas at 25 °C is 2 MPa or more.

### BRIEF DESCRIPTION OF DRAWINGS

Fig. 1 is a schematic sectional view of a laminate according to one embodiment of the present invention.
Fig. 2A is a schematic sectional view showing a state where a first semiconductor chip is picked up from a dicing tape by a collet.
Fig. 2B is a schematic sectional view showing a state where a second semiconductor chip is picked up from the dicing tape by the collet.
Fig. 3A is a schematic sectional view showing a state where a part of an adhesive sheet of the laminate is transferred to the first semiconductor chip.
Fig. 3B is a schematic sectional view showing a state where a part of the adhesive sheet of the laminate is transferred to the second semiconductor chip.
Fig. 4A is a schematic sectional view showing a state where the first semiconductor chip with the adhesive sheet is picked up from the laminate by the collet.
Fig. 4B is a schematic sectional view showing a state where the second semiconductor chip with the adhesive sheet is picked up from the laminate by the collet.
Fig. 5A is a schematic sectional view showing a state where the first semiconductor chip with the adhesive sheet is mounted on a first die pad of a lead frame.
Fig. 5B is a schematic sectional view showing a state where the second semiconductor chip with the adhesive sheet is mounted on a second die pad of the lead frame.
Fig. 6A is a schematic sectional view showing an example of a secondary heating step.
Fig. 6B is a schematic sectional view showing another example of the secondary heating step.

### DETAILED DESCRIPTION OF THE PREFERRED EMBODIMENT

Hereinafter, a description will be given on an embodiment of the present invention.

### Adhesive sheet

First, an adhesive sheet used for the method for producing a semiconductor device according to this embodiment will be described prior to the description on the method for producing a semiconductor device according to this embodiment.

The adhesive sheet has adhesion surfaces respectively on one side and the other side, to each of which an adherend is bonded. The adhesive sheet includes sinterable metal particles that can be sintered by heating at a temperature of 400 °C or less. Since the adhesive sheet thus includes the aforementioned sinterable metal particles, a sintered layer is formed when the adhesive sheet is heated to a temperature at which the sinterable metal particles can be sintered. Thus, the adhesiveness between the adherend on one side and its corresponding sintered layer and the adhesiveness between the adherend on the other side and its corresponding sintered layer are secured. Further, the sintered layer is formed to cause the adherend bonded to one side of the adhesive sheet and the adherend bonded to the other side of the adhesive sheet to be electrically connected to each other. The sinterable metal particles that can be sintered by heating at a temperature of 400 °C or less herein mean the sinterable metal particles in which necking is observed on the outer surfaces of adjacent particles when heated at a temperature of 400 °C or less. The sintering temperature of the sinterable metal particles can be measured using a thermal gravimetric differential thermal analyzer. Specifically, measurement is performed using a thermal gravimetric differential thermal analyzer (TG8120, a differential thermal balance manufactured by Rigaku Corporation) in the following conditions to obtain a Tg curve and a DTA curve, and determine a largest peak temperature of the DTA curve which appears around the start point of the downward slope of the Tg curve.

### <Measurement conditions>

- Temperature rising rate: 10 °C/min
- Measurement atmosphere: Air atmosphere
- Measurement temperature range: Room temperature (23 ± 2 °C) to 500 °C

Examples of the sinterable metal particles that can be sintered by heating at a temperature of 400 °C or less include particles of gold, silver, copper, palladium, tin, nickel, or an alloy of these metals. Examples of the sinterable metal particles also include metal oxide. Examples of the metal oxide include silver oxide, copper oxide, palladium oxide, and tin oxide. The sinterable metal particles can be particles having a core-shell structure. Examples of the particles having the core-shell structure include particles including a core composed of copper and a shell that covers the core and is composed of gold, silver, or the like. Because the adhesive sheet can be a sintered layer to be more firmly bonded to the adherend after sintering, the sinterable metal particles preferably include at least one kind of particles selected from the group consisting of silver, copper, silver oxide, and copper oxide. Because the adhesive sheet can be excellent in electrical conductivity and heat conductivity after sintering, the sinterable metal particles preferably include at least one kind of particles selected from the group consisting of silver and copper. In terms of improving oxidation resistance, the sinterable metal particles preferably include silver particles. The sinterable metal particles including the silver particles can suppress the sinterable metal particles from being oxidized when the sinterable metal particles are sintered in the air atmosphere. Further, the sinterable metal particles can include a combination of particles that include cores composed of copper and shells composed of silver covering the cores (hereinafter also referred to as silver-coated copper particles), and silver particles. The sinterable metal particles are included in the adhesive sheet as primary particles or secondary particles formed by aggregation of the primary particles.

A volume-average particle size D₅₀ of the sinterable metal particles is preferably 0.01 µm or more, more preferably 0.1 µm or more. The volume-average particle size D₅₀ of the sinterable metal particles is preferably 10 µm or less, more preferably 5 µm or less, particularly preferably 1 µm or less. In the case where the sinterable metal particles are composed of two or more different particles, the volume-average particle size D₅₀ means the value measured in a state where two or more different particles are mixed.

The volume-average particle sizes D₅₀ and D₉₀ of the sinterable metal particles can be measured using, for example, a laser diffraction and scattering type particle size distribution measuring apparatus (Microtrac MT3000II series manufactured by MicrotracBEL) on a volume basis.

The adhesive sheet includes a binder in addition to the sinterable metal particles that can be sintered by heating at a temperature of 400 °C or less. The adhesive sheet can include, for example, a plasticizer in addition to the sinterable metal particles and the binder. The binder includes a high molecular binder and binders other than the high molecular binder (hereinafter also referred to as a low molecular binder).

The high molecular binder is preferably a thermally-degradable high molecular binder. The thermally-degradable high molecular binder is a binder thermally degraded at a temperature at which the sinterable metal particles can be sintered. The thermally-degradable high molecular binder maintains the shape of the adhesive sheet until the sinterable metal particles are sintered. In this embodiment, the thermally-degradable high molecular binder is preferably in a solid form at normal temperature (23 °C ± 2 °C) in terms of easiness of maintaining the shape of the adhesive sheet. Examples of such a thermally-degradable high molecular binder include a polycarbonate resin and an acrylic resin.

Examples of the polycarbonate resin include an aliphatic polycarbonate and an aromatic polycarbonate. The aromatic polycarbonate has a benzene ring between the carbonate ester groups (-O-CO-O-) of the main chain. The aliphatic polycarbonate has an aliphatic chain with no benzene ring between the carbonate ester groups (-O-CO-O-) of the main chain. Examples of the aliphatic polycarbonate include polyethylene carbonate and polypropyrene carbonate. Examples of the aromatic polycarbonate include polycarbonate having a bisphenol-A structure in the main chain.

The acrylic resin has a (meth)acrylic acid ester as a constituent unit. Examples of the (meth)acrylic acid ester include a linear or branched (meth)acrylic acid ester having a 4-18C alkyl group. Examples of the alkyl group include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin may have a monomer other than the (meth)acrylic acid ester as a constituent unit. Examples of the monomer other than the (meth)acrylic acid ester include a carboxy group-containing monomer, an acid anhydride monomer, a hydroxy group-containing monomer, a sulfonic acid group-containing monomer, and a phosphate group-containing monomer.

Examples of the carboxy group-containing monomer include acrylic acid, methacrylic acid, carboxyethyl (meth)acrylate, carboxypentyl (meth)acrylate, itaconic acid, maleic acid, fumaric acid, and crotonic acid. Examples of the acid anhydride monomer include maleic anhydride and itaconic anhydride. Examples of the hydroxy group-containing monomer include 2-hydroxyethyl (meth)acrylic acid, 2-hydroxypropyl (meth)acrylic acid, 4-hydroxybutyl (meth)acrylic acid, 6-hydroxyhexyl (meth)acrylic acid, 8-hydroxyoctyl (meth)acrylic acid, 10-hydroxydecyl (meth)acrylic acid, 12-hydroxylauryl (meth)acrylic acid, and 4-(hydroxymethyl) cyclohexylmethyl (meth)acrylic acid. Examples of the sulfonic acid group-containing monomer include styrenesulfonic acid, arylsulfonic acid, 2-(meth)acrylamide-2-methylpropanesulfonic acid, (meth)acrylamidepropanesulfonic acid, sulfopropyl (meth)acrylate, and (meth)acryloyloxynaphthalenesulfonic acid. Examples of the phosphate group-containing monomer include 2-hydroxyethyl acryloyl phosphate.

In the description herein, "(meth)acrylic" herein means a concept including acrylic and methacrylic. Also, "(meth)acrylate" herein means a concept including acrylate and methacrylate.

A volume-average molecular weight of the high molecular binder is preferably 10,000 or more. The volume-average molecular weight herein means a value measured by a gel permeation chromatography (GPC) and converted in terms of polystyrene. For example, the volume-average molecular weight can be obtained as a value converted in terms of polystyrene by calculation from the result of GPC measurement at a column temperature of 40 °C and a flow rate of 0.5 ml/min, using: as an apparatus, GPC "HLC-8320GPC" manufactured by Tosoh Corporation; as columns, three columns in total of "TSK guardcolumn HHR (S)" manufactured by Tosoh Corporation, "TSK GMHHR-H (S)" manufactured by Tosoh Corporation, and "TSK GMHHR-H (S)" manufactured by Tosoh Corporation, which are connected in series; as a reference column, "TSK gel Super H-RC "; and, as an eluent, tetrahydrofuran (THF).

The low molecular binder preferably includes a low boiling point binder having a boiling point lower than the initial temperature of thermal decomposition of the thermally-degradable high molecular binder. The low molecular binder is preferably in a liquid form at 23 °C. Further, the low molecular binder preferably has a viscosity of 1 × 10⁵ Pa·s at 23 °C. The viscosity can be measured by a dynamic viscoelasticity measurement instrument (product name "HAAKE MARS III" manufactured by Thermo Fisher Scientific). The measurement herein is performed by using parallel plates having a diameter of 20 mm as a jig, setting a gap between the plates at 100 µm, and setting a shear rate in rotary shearing at 1s⁻¹.

Examples of the low molecular binder include alcohols and ethers. Examples of the alcohols include terpene alcohols. Examples of the terpene alcohols include isobornyl cyclohexanol, citronellol, geraniol, nerol, carveol, and α-terpineol. Examples of the alcohols other than the terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the ethers include alkylene glycol alkyl ethers. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl methyl ether, dipropylene glycol dimethyl ether, tripropylene glycol methyl ether, and tripropylene glycol dimethyl ether. Examples of the ethers other than the alkylene glycol alkyl ethers include ethylene glycol ethyl ether acetate, ethylene glycol butyl ether acetate, diethylene glycol ethyl ether acetate, diethylene glycol butyl ether acetate, and dipropylene glycol methyl ether acetate.

The low molecular binder is preferably terpene alcohols, more preferably isobornyl cyclohexanol. Here, isobornyl cyclohexanol is an organic compound having a boiling point of 308 to 318 °C and an extremely high viscosity of 1000000 mPa·s at 25 °C, while having such characteristics that, in the case where the temperature is raised from room temperature to 600 °C in a nitrogen gas flow of 200 ML/min and heating conditions of 10 °C/min, its mass is greatly reduced when the temperature is 100 °C or more, and it volatilizes and vanishes at 245 °C (i.e., further mass reduction is not recognized). Isobornyl cyclohexanol has an extremely high viscosity at 25 °C as described above and thus enables to keep the shape of the sheet at room temperature when it is included in the adhesive sheet. Further, in this embodiment, the sinterable metal particles included in the adhesive sheet are metal particles that can be sintered by heating at a temperature of 400 °C or less, and in general, such sinterable metal particles are sintered at a temperature of about 200 to 300 °C. That is, the temperature between 200 and 300 °C is adopted as a sintering temperature. Thus, in the case where isobornyl cyclohexanol is included in the adhesive sheet and the aforementioned sintering temperature is adopted, isobornyl cyclohexanol volatilizes to the outside of the adhesive sheet during the sintering so that the sinterable metal particles are located close to each other in the adhesive sheet. Thereby, the sintering of the sinterable metal particles in the adhesive sheet can be further advanced. The mass reduction herein means the value when the mass reduction rate at a measurement starting temperature (i.e., room temperature) is referred to as 0%.

A content ratio (particle filling ratio) of the sinterable metal particles in the adhesive sheet is preferably 85 mass% or more and 97 mass% or less, more preferably 88 mass% or more and 96 mass% or less. The adhesive sheet includes the sinterable metal particles of 85 mass% or more so that electric conductivity after sintering can be easily and sufficiently exhibited. The adhesive sheet includes the sinterable metal particles of 97 mass% or less so that the shape of the adhesive sheet can be easily kept. The content ratio of the sinterable metal particles in the adhesive sheet herein means a content ratio before the sinterable metal particles are sintered.

A content ratio of the high molecular binder in the adhesive sheet is preferably 0.1 mass% or more and 10 mass% or less, more preferably 0.5 mass% or more and 5 mass% or less. The adhesive sheet including the high molecular binder of 0.1 mass% or more enables to easily keep the shape of the adhesive sheet. The adhesive sheet including the high molecular binder of 10 mass% or less enables to reduce a residue component derived from the high molecular binder after sintering.

A content ratio of the low molecular binder in the adhesive sheet is preferably 1 mass% or more and 20 mass% or less, more preferably 2 mass% or more and 15 mass% or less. The adhesive sheet including the low molecular binder of 1 mass% or more enables the adhesive sheet to be excellent in transferability to the adherend. The adhesive sheet including the low molecular binder of 20 mass% or less enables to reduce a residue component derived from the low molecular binder after sintering.

A thickness of the adhesive sheet is preferably 5 µm or more, more preferably 10 µm or more. The thickness of the adhesive sheet is preferably 300 µm or less, more preferably 150 µm or less. The thickness of the adhesive sheet can be determined by, for example, measuring a thickness of each of any five points chosen at random using a dial gage (manufactured by PEACOCK, product type: R-205), followed by determining the arithmetic mean of these thicknesses.

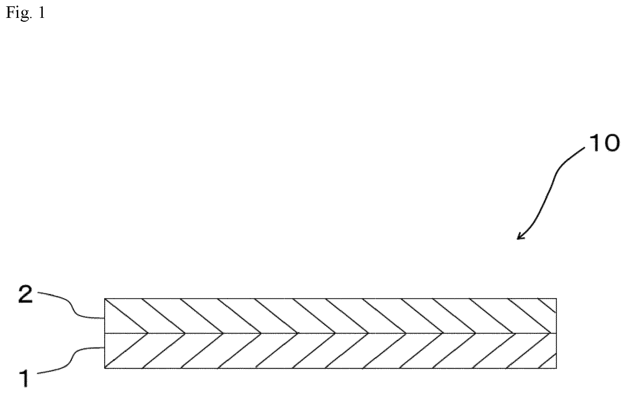

As shown in Fig. 1, the adhesive sheet 2 configured as described above is used for production of a semiconductor device in the form of a laminate 10 in which the adhesive sheet is laminated on the substrate sheet 1. In the laminate 10, the adhesive sheet 2 is releasably laminated on the substrate sheet 1.

The substrate sheet 1 is a resin layer including a resin. Examples of the resin included in the resin layer include a polyolefin resin, a polyester resin, a polyurethane resin, a polycarbonate resin, a polyetheretherketone resin, a polyimide resin, a polyetherimide resin, a polyamide resin, a polyvinyl chloride resin, a polyvinylidene chloride resin, a polyphenyl sulfide resin, a fluorine resin, a cellulose-based resin, and a silicone resin.

A thickness of the substrate sheet 1 is preferably 10 µm or more and 5000 µm or less, more preferably 20 µm or more and 4000 µm or less, still more preferably 30 µm or more and 3000 µm or less. The thickness of the substrate sheet 1 can be determined by, for example, measuring a thickness of each of any five points chosen at random using a dial gage (manufactured by PEACOCK, product type: R-205), followed by determining the arithmetic mean of these thicknesses.

### [Method for producing a semiconductor device]

A method for producing a semiconductor device according to an embodiment of the present invention (hereinafter also referred to as this embodiment) is a method for producing a semiconductor device including: a semiconductor chip-mounting step of subsequently pressing a plurality of semiconductor chips by a first pressing member to respectively bond the plurality of semiconductor chips to a plurality of mounting areas provided on a substrate, wherein the bonding is performed in a state where adhesive sheets are respectively interposed between the plurality of semiconductor chips and the plurality of mounting areas, each of the adhesive sheets includes sinterable metal particles that can be sintered by heating at a temperature of 400 °C or less, and the first pressing member is heated to a temperature at which the sinterable metal particles can be sintered.

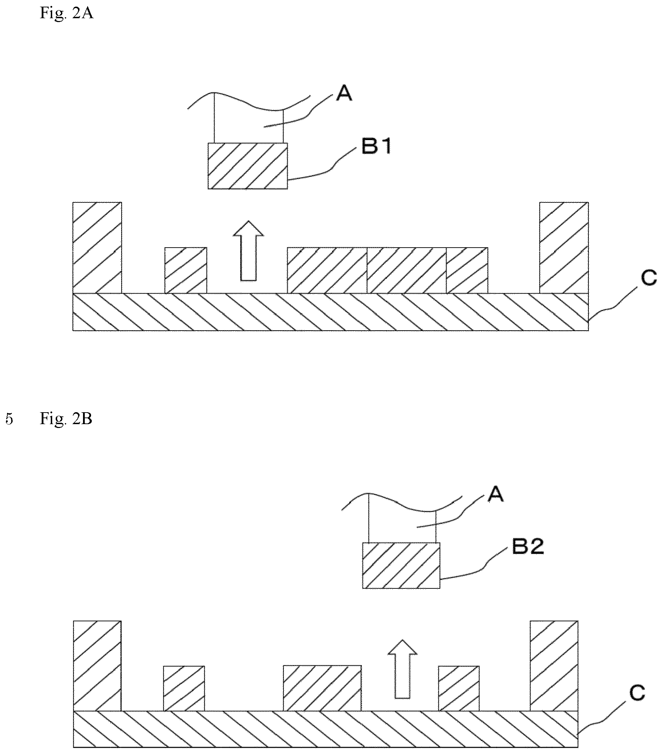

Hereinafter, a description will be given on, with reference to Fig. 2A to Fig. 5B, an example of the method for producing a semiconductor device using the laminate 10. The following provides a description by taking the case where the substrate is a lead frame substrate, each of the mounting area is a die pad, and the first pressing member is a collet.

First, a semiconductor wafer is cut on a dicing tape to obtain a plurality of semiconductor chips. Next, as shown in Fig. 2A, one semiconductor chip B1 (hereinafter also referred to as the first semiconductor chip B1) of the plurality of semiconductor chips is picked up from a dicing tape C by a collet A. In general, the semiconductor chip has a rectangular shape in plan view, more specifically, have a square shape in plan view. A thickness of the semiconductor chip is, for example, 10 µm or more and 500 µm or less, more specifically 20 µm or more and 400 µm or less. An area of the semiconductor chip in plan view is, for example, 0.01 mm² or more and 1000 mm² or less, more specifically 0.04 mm² or more and 500 mm² or less. Further, a dimension of the collet A on the side in contact with the semiconductor chip corresponds to the chip size. That is, an area S1 (hereinafter also referred to as the collet area S1) of the collet A on the side in contact with the semiconductor chip in plan view corresponds to an area S2 (hereinafter also referred to as the chip area S2) of the semiconductor chip in plan view. More specifically, the collet area S1 is 0.9 times or more and 1.1 times or less as large as the chip area S2.

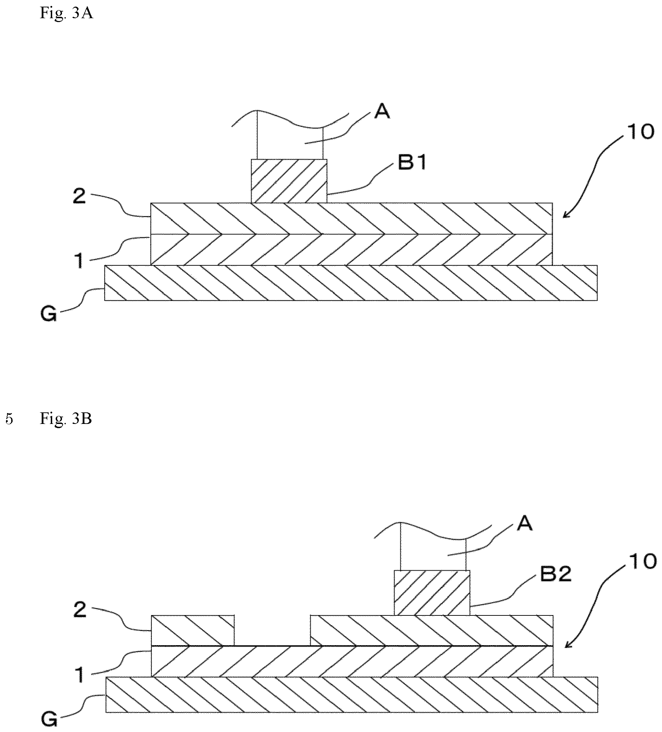

Next, as shown in Fig. 3A, the laminate 10 is mounted on a stage G with the adhesive sheet 2 placed on the upper side in the laminate 10. Then, the first semiconductor chip B1 is pressed onto the adhesive sheet 2 of the laminate 10 by the collet A to transfer a part of the adhesive sheet 2 to the first semiconductor chip B1. Thereby, the first semiconductor chip B1 with the adhesive sheet 2 can be obtained. The pressure for pressing the first semiconductor chip B1 onto the adhesive sheet 2 is preferably 0.01 MPa or more and 10 MPa or less, more preferably 0.1 MPa or more and 5 MPa or less. A temperature of the collet A or the stage G when the first semiconductor chip B1 is pressed onto the adhesive sheet 2 is preferably 40 °C or more and 150 °C or less, more preferably 50 °C or more and 120 °C or less.

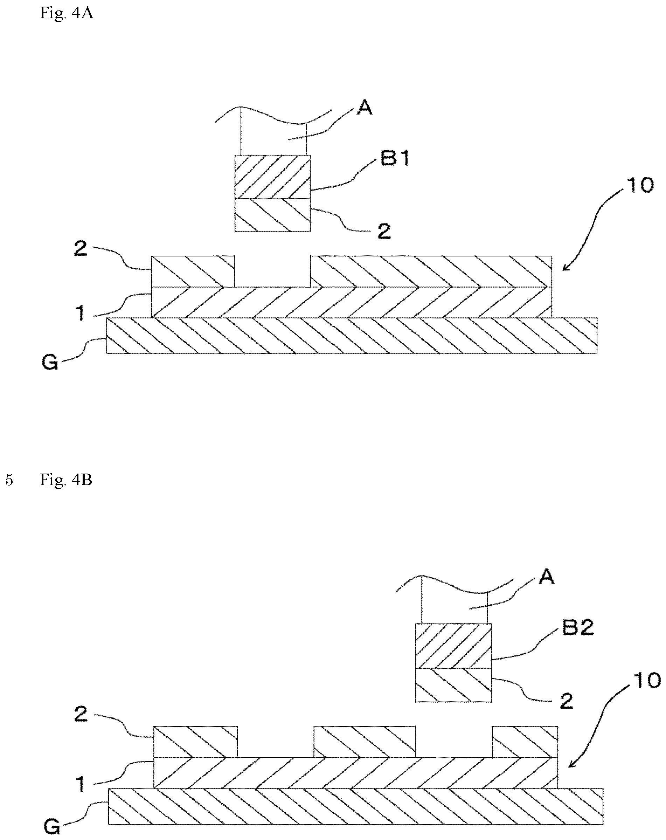

Next, as shown in Fig. 4A, the first semiconductor chip B1 with the adhesive sheet 2 is picked up from the laminate 10 by the collet A.

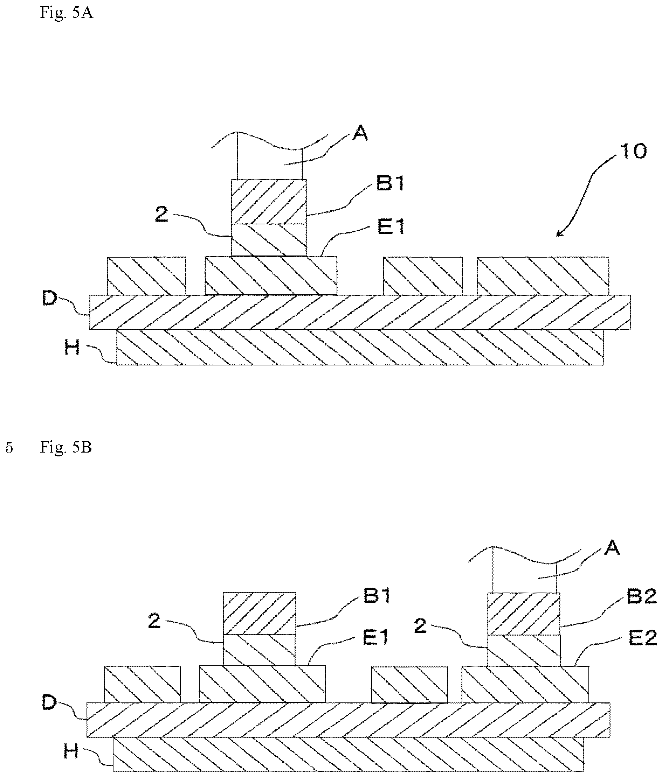

Next, as shown in Fig. 5A, a lead frame substrate D is mounted on a stage H. Next, the collet A that is kept at a temperature in the range between 25 °C and 100 °C is moved vertically downward to allow the first semiconductor chip B1 with the adhesive sheet 2 to come into contact with a die pad E1 (i.e., the first die pad E1) in the lead frame substrate D from the adhesive sheet 2 side. Next, the first semiconductor chip B1 with the adhesive sheet 2 is applied with pressure or pressed by the collet A onto the first die pad E1 of the lead frame substrate D while being held in contact with the first die pad E1. In this state, the collet A is heated to a temperature at which the sinterable metal particles (i.e., the sinterable metal particles included in the adhesive sheet 2) can be sintered, thereby subjecting the sinterable metal particles in the adhesive sheet 2 to a primary sintering (see Fig. 5A). The pressure for pressing the first semiconductor chip B1 with the adhesive sheet 2 onto the first die pad E1 of the lead frame substrate D from the adhesive sheet 2 side is preferably 0.01 MPa or more and 50 MPa or less, more preferably 0.1 MPa or more and 30 MPa or less. It is preferable that the collet A be heated to a temperature of 250 °C or higher. Since the sinterable metal particles can be sufficiently sintered by heating the collet A to a temperature of 250 °C or higher, the semiconductor chip can be further firmly mounted on the substrate with the adhesive sheet interposed therebetween. That is, the connection reliability of the semiconductor chips to the substrate can be improved. Further, it is preferable that the collet A be rapidly heated (in about 5 seconds) to a temperature at which the sinterable metal particles can be sintered. The collet A is heated to a temperature at which the sinterable metal particles can be sintered at a heating rate of preferably 30 °C/sec or more, more preferably 45 °C/sec or more. The primary sintering can be performed by heating the stage H, in addition to the collet A, to a temperature equal to or higher than the temperature at which the sinterable metal particles can be sintered. Thereby, the heating can be performed from both sides of the adhesive sheet 2 so that the sinterable metal particles can be further sufficiently sintered. As a result, the semiconductor chip can be further firmly mounted on the substrate with the adhesive sheet interposed therebetween. That is, the connection reliability of the semiconductor chips to the substrate can be further improved. The temperature for heating the stage H is preferably equal to or lower than the temperature at which the lead frame substrate D is suppressed from being oxidized. For example, in the case where the lead frame substrate D is composed of a Cu alloy (e.g., Cu-Cr-Zr, Cu-Cr-Sn-Zn, and Cu-Ni-Si-Mg), the temperature for heating the stage H is preferably 150 °C or less.

After the primary sintering of the sinterable metal particles, the collet A is pulled upward to be separated from the first semiconductor chip B1 with the adhesive sheet 2, and the temperature of the collet A is lowered to a temperature at which the sinterable metal particles can be barely sintered (for example, 50 °C).

After the temperature of the collet A is lowered as described above, as shown in Fig. 2B, another semiconductor chip B2 (hereinafter also referred to as the second semiconductor chip B2) of the plurality of semiconductor chips is picked up from the dicing tape C by the collet A. Next, as shown in Fig. 3B, the second semiconductor chip B2 is pressed onto the adhesive sheet 2 of the laminate 10 by the collet A to transfer a part of the adhesive sheet 2 to the second semiconductor chip B2. Thereby, the second semiconductor chip B2 with the adhesive sheet 2 can be obtained. Next, as shown in Fig. 4B, the second semiconductor chip B2 with the adhesive sheet 2 is picked up from the dicing tape C by the collet A. Next, the second semiconductor chip B2 with the adhesive sheet 2 is brought into contact with another die pad E2 (i.e., the second die pad E2) in the lead frame substrate D from the adhesive sheet 2 side, while the collet A is kept at a temperature in the range between 25 °C and 100 °C. Next, the second semiconductor chip B2 is applied with pressure or pressed by the collet A onto the second die pad E2 of the lead frame substrate D while being adhesive sheet 2 held in contact with the second die pad E2. In this state, the sinterable metal particles included in the adhesive sheet 2 are subjected to a primary sintering (see Fig. 5B). The heating temperature of the collet A and the pressure for pressing the first semiconductor chip B1 with the adhesive sheet 2 onto the die pad E2 of the lead frame substrate D from the adhesive sheet 2 side are selected from the aforementioned values. After the primary sintering of the sinterable metal particles, the collet A is pulled upward to be thereby separated from the second semiconductor chip B2 with the adhesive sheet 2, and the temperature of the collet A is lowered to a temperature at which the sinterable metal particles cannot be sintered (for example, 50 °C). The aforementioned steps are subsequently repeated until the semiconductor chips are respectively mounted on all of the die pads of the lead frame substrate D. The semiconductor chip-mounting step is performed in this manner. A bonding wire can be applied at a part required to be applied for bonding after the semiconductor chips are respectively mounted on all of the die pads of the lead frame substrate D, that is, after the semiconductor chip-mounting step.

As described above, according to the method for producing the semiconductor device of this embodiment, in addition to subsequently pressing the semiconductor chips (the first semiconductor chip B1, the second semiconductor chip B2) by the first pressing member (the collet A) to respectively bond the plurality of semiconductor chips to the plurality of mounting areas provided on the substrate (the lead frame substrate D), the semiconductor chips (the first semiconductor chip B1, the second semiconductor chip B2) are pressed using the first pressing member (the collet A) that has been heated to a temperature at which the sinterable metal particles included in the adhesive sheet 2 can be sintered. Thus, the plurality of semiconductor chips (the first semiconductor chip B1, the second semiconductor chip B2) can be relatively uniformly mounted one by one on the mounting areas (the first die pad E1, the second die pad E2) of the substrate (the lead frame substrate D) with the adhesive sheet 2 interposed therebetween. Thereby, uneven adhesion can be relatively suppressed when the plurality of semiconductor chips (the first semiconductor chip B1, the second semiconductor chip B2) are mounted on the substrate (the lead frame substrate D) with the adhesive sheet 2 interposed therebetween.

It is preferable that the method for producing the semiconductor device according to this embodiment further include: performing, after the semiconductor chip-mounting step, a secondary heating step of heating the substrate with the plurality of semiconductor chips mounted thereon to a temperature, at which the sinterable metal particles can be sintered, wherein in the secondary heating step, the aforementioned heating is performed while not pressing part or all of the plurality of semiconductor chips onto the substrate. Further, in the secondary heating step of the method for producing a semiconductor device according to this embodiment, it is preferable that the aforementioned heating be performed while not pressing all of the plurality of semiconductor chips onto the substrate.

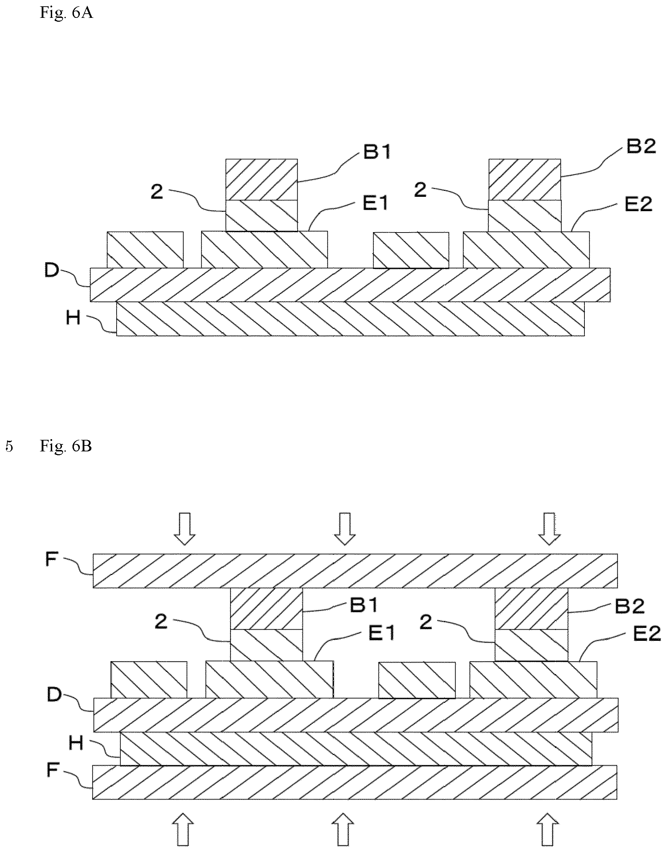

More specifically, the stage H can be heated to the temperature at which the sinterable metal particles included in the adhesive sheet 2 can be sintered, in the state where, as shown in Fig. 6A, part or all of the plurality of semiconductor chips mounted on all of the die pads of the lead frame substrate D are not being pressed after the semiconductor chips are respectively mounted on all of the die pads of the lead frame substrate D (i.e., after the semiconductor chip-mounting step). That is, the secondary heating step can be performed. Examples of the temperature at which the sinterable metal particles are sintered include any temperature in the range between 200 °C to 400 °C. Fig. 6A shows an example of heating performed in the state where all of the semiconductor chips mounted on all of the die pads (the first die pad E1 and the second die pad E2) of the lead frame substrate D are not being pressed. It is possible to further sinter the sinterable metal particles by performing the secondary heating step. That is, since the secondary sintering can be performed, it is possible to more firmly mount the semiconductor chips on the substrate (the lead frame substrate D) with the adhesive sheet interposed therebetween. That is, the connection reliability of the semiconductor chips to the substrate can be improved. Further, a facility for use in the secondary heating step can have a simplified configuration that does not include a pressing member for pressing part or all of the plurality of semiconductor chips. Even in the case where the secondary heating step as aforementioned is performed, a bonding wire can be applied at a part required to be applied after the secondary heating step.

The method for producing a semiconductor device according to this embodiment may be configured such that after the semiconductor chip-mounting step, a secondary heating step of heating the substrate with the plurality of semiconductor chips mounted thereon to a temperature at which the sinterable metal particles can be sintered is performed, wherein in the secondary heating step, the aforementioned heating is performed while pressing part or all of the plurality of semiconductor chips onto the substrate. Further, in the method for producing a semiconductor device according to this embodiment, the secondary heating step may be configured such that the aforementioned heating is performed while pressing all of the plurality of semiconductor chips onto the substrate.

More specifically, the semiconductor chips can be heated at the temperature at which the sinterable metal particles can be sintered, in the state where, as shown in Fig. 6B, while part or all of the semiconductor chips mounted on all of the die pads of the lead frame substrate D are applied with pressure, that is, pressed, using a heating and pressing device F that includes two flat plates (parallel flat plates) that are configured to be able to apply heat and are located to sandwich, from above and below, part or all of the semiconductor chips mounted on all of the die pads of the lead frame substrate D, after the semiconductor chips are respectively mounted on all of the die pads of the lead frame substrate D, that is, after the semiconductor chip-mounting step is performed.

That is, the secondary heating step can be performed. Fig. 6B shows an example of heating all of the semiconductor chips mounted on all of the die pads (the first die pad E1 and the second die pad E2) of the lead frame substrate D while pressing them. According to the secondary heating step performed in this way, part or all of the plurality of semiconductor chips can be heated while pressing them onto the substrate (the lead frame substrate D). Thus, the part or all of the plurality of semiconductor chips can be further firmly mounted on the substrate (the lead frame substrate D) with the adhesive sheet interposed therebetween. That is, the connection reliability of the semiconductor chips to the substrate can be further improved. Also, in the case where the secondary heating step as aforementioned is performed, a bonding wire can be applied at a part required to be applied after the secondary heating step.

Various types of known lead frame substrates can be adopted as the lead frame substrate D. Examples of the various types of known lead frame substrates include a lead frame substrate formed of a Cu lead frame substrate subjected to Ag plating, and a lead frame substrate (e.g., Palladium Pre Plated Lead Frame. Pd-PPF) formed by plating a Cu lead frame substrate with Ni, Pd, and Au in this order.

### Semiconductor device

A semiconductor device according to this embodiment is a semiconductor device is a semiconductor device produced by the method for producing the semiconductor device according to this embodiment. The semiconductor device according to this embodiment has a shear strength between each one of the plurality of semiconductor chips and the substrate at 25 °C is 2 MPa or more. The shear strength at 25 °C being 2 MPa or more enables the semiconductor device according to this embodiment to have an improved connection reliability of the semiconductor chips to the substrate. The shear strength at 25 °C can be 200 MPa or less.

The shear strength at 25 °C can be measured in the following manner. Specifically, a bare chip with an adhesive sheet is mounted on a die pad of a lead frame substrate to obtain a test sample, and measurement of a shear strength at 25 °C of the test sample is performed under the conditions described below, using a universal bond tester series 4000 manufactured by Nordson Advanced Technology (Japan) K.K.

### <Shear strength measurement conditions>

- Load cell: DS 100 kg
- Measurement range: 100 kg
- Test type: Destructive test
- Test speed: 100 µm/s
- Descending speed: 100 µm/s
- Test height: 100 µm
- Moving amount: 2000 µm
- Destruction recognizing point: Low (10%)

Matters disclosed herein by the present application include the matters as follows:
(1) A method for producing a semiconductor device, including: a semiconductor chip-mounting step of subsequently pressing a plurality of semiconductor chips by a first pressing member to respectively bond the plurality of semiconductor chips to a plurality of mounting areas provided on a substrate, wherein the bonding is performed in a state where adhesive sheets are respectively interposed between the plurality of semiconductor chips and the plurality of mounting areas, each of the adhesive sheets each includes sinterable metal particles that can be sintered by heating at a temperature of 400 °C or less, and the first pressing member is heated to a temperature at which the sinterable metal particles can be sintered.

As described above, according to the semiconductor chip-mounting step having the above configuration, in addition to subsequently pressing the plurality of semiconductor chips by the first pressing member to the plurality of mounting areas of the substrate to respectively bond the semiconductor chips, the semiconductor chips are pressed using the first pressing member that has been heated to a temperature at which the sinterable metal particles included in the adhesive sheet 2 can be sintered. Thus, the plurality of semiconductor chips can be relatively uniformly mounted one by one on the mounting areas with the adhesive sheet interposed therebetween. Thereby, it is possible to relatively suppress uneven adhesion when the plurality of semiconductor chips are mounted on the substrate with the adhesive sheet interposed therebetween.

(2) The method for producing a semiconductor device according to (1) above, further includes: performing, after the semiconductor chip-mounting step, a secondary heating step of heating the substrate with the plurality of semiconductor chips mounted thereon to a temperature, at which the sinterable metal particles can be sintered, wherein in the secondary heating step, the aforementioned heating is performed while not pressing part or all of the plurality of semiconductor chips onto the substrate.

According to such a configuration, it is possible to more firmly mount part or all of the plurality of semiconductor chips on the substrate with the adhesive sheet interposed therebetween. That is, the connection reliability of part or all of the plurality of semiconductor chips to the substrate can be improved. Further, a facility for use in the secondary step can have a simplified configuration that does not include a pressing member for pressing part or all of the plurality of semiconductor chips.

(3) According to the method for producing the semiconductor device according to (2) above, the secondary heating step is configured such that the aforementioned heating is performed while not pressing all of the plurality of semiconductor chips onto the substrate.

According to such a configuration, it is possible to firmly mount all of the plurality of semiconductor chips on the substrate with the adhesive sheet interposed therebetween. That is, the connection reliability of all of the semiconductor chips to the substrate can be improved.

(4) The method for producing the semiconductor device according to (1) above, further includes: performing, after the semiconductor chip-mounting step, a secondary heating step of heating the substrate with the plurality of semiconductor chips mounted thereon to a temperature at which the sinterable metal particles can be sintered, wherein in the secondary heating step, the aforementioned heating is performed while pressing part or all of the plurality of semiconductor chips onto the substrate.

According to the above configuration, the heating is performed in the secondary heating step, while pressing part or all of the plurality of semiconductor chips onto the substrate. Thus, it is possible to further firmly mount part or all of the plurality of semiconductor chips on the substrate with the adhesive sheet interposed therebetween. That is, the connection reliability of all of the semiconductor chips to the substrate can be further improved.

(5) According to the method for producing a semiconductor device according to (4) above, the secondary heating step is configured such that the aforementioned heating is performed while pressing all of the plurality of semiconductor chips onto the substrate.

According to the above configuration, it is possible to more firmly mount all of the plurality of semiconductor chips on the substrate with the adhesive sheet interposed therebetween. That is, the connection reliability of all of the semiconductor chips to the substrate can be further improved.

(6) According to the method for producing a semiconductor device according to any one of (1) to (5) above, the semiconductor chip-mounting step is configured such that the first pressing member is heated to a temperature of 250 °C or more.

According to the above configuration, it is possible to more firmly mount each of the plurality of semiconductor chips on the substrate with the adhesive sheet interposed therebetween. That is, the connection reliability of each of the plurality of the semiconductor chips to the substrate can be further improved.

(7) A semiconductor device produced by the method for producing the semiconductor device according to any one of (1) to (6) above, wherein a shear strength between one of the plurality of semiconductor chips and a corresponding one of the plurality of mounting areas at 25 °C is 2 MPa or more.

According to the above configuration, the semiconductor device can be improved in terms of the connection reliability of each of the plurality of the semiconductor chips to the substrate.

The semiconductor device and the method for producing the semiconductor device according to the present invention are not limited to the aforementioned embodiment. The semiconductor device and the method for producing the semiconductor device according to the present invention are not limited by the aforementioned operational advantages, either. Various modifications can be made for the semiconductor device and the method for producing the semiconductor device according to the present invention without departing from the gist of the present invention.

The method for producing the semiconductor device according to the aforementioned embodiment was described by taking, for example, the case where the plurality of semiconductor chips are subsequently mounted on the die pads of the lead frame substrate with the adhesive sheet interposed therebetween, while a single collet is heated and cooled, but examples of mounting the plurality of semiconductor chips on the lead frame substrate are not limited to this example. The plurality of semiconductor chips can be subsequently mounted on the die pads of the lead frame substrate with the adhesive sheet interposed therebetween, while two or more of collets are alternately heated and cooled. According to this configuration, it is possible to eliminate the necessity of withholding the subsequent step until the temperature of one collet is lowered to a certain temperature or below after one of the plurality of semiconductor chips is mounted on one of die pads of the lead frame by the one collet. Thus, it is possible to continuously mount another one of the plurality of semiconductor chips on another one of die pads of the lead frame by another one of the collets. Thereby, the takt time can be shortened in the production of the semiconductor device.

Further, the method for producing the semiconductor device according to the aforementioned embodiment was described by taking, for example, the case where a collet is used as the first pressing member, but the first pressing member is not limited to the collet. Any member or part can be used as long as it can subsequently press, while heating, the plurality of semiconductor chips on the plurality of die pads of the lead frame substrate. Examples of the member or part that can subsequently press, while heating, as aforementioned include a member or part having an area of a pressing surface in plan view 0.9 times or more and 1.1 times or less as large as the area of the semiconductor chip in plan view.

### EXAMPLES

Next, the present invention will be more specifically described with reference to the examples. The following examples are provided for more specifically describing the present invention, and do not intend to limit the scope of the present invention.

### <Laminate>

The following materials were mixed in the respective mass ratio below for 3 minutes using a hybrid mixer (product name: "HM-500" manufactured by KEYENCE CORPORATION) in the "stirring mode" to prepare a varnish.

### • Sinterable metal particles: 93.2 parts by mass

The sinterable metal particles are mixed particles of primary silver particles (product name "DF-SNI-003" manufactured by DOWA Electronics Materials Co., Ltd.; and a volume average particle size D₅₀ of 60 µm) and secondary silver particles (SPQ05S manufactured by Mitsui Mining & Smelting Co., Ltd.; and a volume average particle size D₅₀ of 1.1 µm), in which a mass ratio of the primary silver particles is 83.9 mass% and a mass ratio of the secondary silver particles is 9.3 mass%.

### • High molecular binder: 1.4 parts by mass

The high molecular binder is a polycarbonate resin (product name "QPAC40"; Empower Materials, Inc.; a mass-average molecular weight of 150000; and a solid form at a room temperature) that is a thermal decomposable binder.

### • Low molecular binder: 5.4 parts by mass

The low molecular binder is isobornyl cyclohexanol (product name "Terusolve MTPH" manufactured by NIPPON TERPENE CHEMICALS, INC.; and a liquid form at a room temperature) that is a low-boiling binder.

### • Methyl ethyl ketone (MEK): appropriate amount

Methyl ethyl ketone is used for adjusting the viscosity of the varnish.

The varnish prepared as aforementioned is applied to a porous polyethylene sheet (porous PE sheet) (thickness: 300 µm) as a substrate sheet, followed by drying to form an adhesive layer (i.e., adhesive sheet) having a thickness of 30 µm to obtain a laminate. A drying temperature was 110 °C and a drying time was 3 minutes. A content ratio of the sinterable metal particles (particle filling ratio) in the adhesive layer (i.e., the adhesive sheet) was 93.2 mass%.

### (Production of a semiconductor chip with an adhesive sheet)

A semiconductor chip with an adhesive sheet was produced using FC3000W manufactured by Toray Engineering Co., Ltd. First, a collet of FC3000W was heated, followed by allowing the collet to press one side of an Si mirror chip (having a plane dimension of 5 mm × 5 mm and a thickness of 200 µm), the one side being entirely coated with silver, to the adhesive layer (i.e., the adhesive sheet) of the laminate. That is, the adhesive layer of the laminate was pressed by the one side of the Si mirror chip. The pressing (applying a pressure) was performed by applying a load of 50 N for 5 seconds. Next, the collet was separated from the laminate at a speed of 0.3 mm/sec to obtain a semiconductor chip with the adhesive sheet in the state of being mounted on the collet.

### [Example 1]

### (Production of a substrate with semiconductor chips)

Three semiconductor chips with adhesive sheets were respectively mounted on three die pads of a Cu lead frame substrate subjected to plating with Ag (hereinafter also referred to the Ag-plated Cu lead frame substrate; a thickness of 3 mm) to obtain a substrate with semiconductor chips. The semiconductor chips with the adhesive sheets were mounted on the die pads of the Ag-plated Cu lead frame substrate using, mainly, FC3000W manufactured by Toray Engineering Co., Ltd. Specifically, the mounting was performed in the following manner. The Ag-plated Cu lead frame substrate was placed on a stage of FC3000W and heated to 150 °C.
(1) The collet in the state where a semiconductor chip with an adhesive sheet (hereinafter referred to as the first semiconductor chip with the adhesive sheet) is mounted on the collect is heated to 100 °C.
(2) The collet heated at 100 °C is moved vertically downward to allow the adhesive sheet of the first semiconductor chip with the adhesive sheet to come into contact with the first die pad of the Ag-plated Cu lead frame substrate.
(3) The collet is heated to 250 °C, while the first semiconductor chip with the adhesive sheet that is held in contact with the first die pad of the Ag-plated Cu lead frame substrate is pressed, that is, is applied with pressure by the collet, to thereby cause the sinterable metal particles in the adhesive sheet to be sintered, that is, to thereby subject the sinterable metal particles in the adhesive sheet to the primary sintering. Thereby, the first semiconductor chip with the adhesive sheet is mounted on the first die pad. The pressing (applying a pressure) by the collet is performed at 10 MPa. The pressing and heating time is 100 sec.
(4) The collet is pulled upward to be thereby separated from the first semiconductor chip with the adhesive sheet, and thereafter the temperature of the collet is lowered to a temperature at which the sinterable metal particles can be barely sintered (i.e., 50 °C).
(5) A second semiconductor chip with an adhesive sheet is obtained using the collet in the state where the second semiconductor chip is mounted on the collet in the same manner as the aforementioned method, and the collet is heated to 100 °C.
(6) In the same manner as in (2) and (3) described above, the second semiconductor chip with the adhesive sheet is mounted on a second die pad of the Ag-plated Cu lead frame substrate.
(7) In the same manner as in (4) described above, the collet is pulled upward to be thereby separated from the second semiconductor chip with the adhesive sheet by picking up the collet, and thereafter the temperature of the collet is lowered to a temperature at which the sinterable metal particles can be barely sintered (i.e., 50 °C).
(8) A third semiconductor chip with the adhesive sheet is mounted by the collet on a third die pad of the Ag-plated Cu lead frame substrate in the same manner as described above.

In the manner mentioned above, the Ag-plated Cu lead frame substrate with the adhesive sheet according to Example 1 in which three semiconductor chips are mounted on the Ag-plated Cu lead frame substrate with the adhesive sheet interposed therebetween was obtained.

### (Measurement of shear strength)

Measurement of the shear strength at 25 °C was performed on the Ag-plated Cu lead frame substrate with semiconductor chips according to Example 1 obtained as described above. Specifically, the measurement of the shear strength at 25 °C was performed by adopting the conditions described below, using a universal bond tester series 4000 manufactured by Nordson Advanced Technology (Japan) K.K.

### <Shear strength measurement conditions>

- Load cell: DS 100 kg
- Measurement range: 100 kg
- Test type: Destructive test
- Test speed: 100 µm/s
- Descending speed: 100 µm/s
- Test height: 100 µm
- Moving amount of the tool: 2000 µm
- Destruction recognizing point: Low (10%)

The shear strength at 25 °C was determined by measuring each of the first to third semiconductor chips respectively with the adhesive sheets and determining the arithmetic mean of these measurement values. The measurement result of the shear strength at 25 °C is shown in Table 2 below.

### [Example 2]

### (Production of a substrate with semiconductor chips)

An Ag-plated Cu lead frame substrate with semiconductor chips according to Example 2 was obtained in the same manner as in Example 1 except that the Ag-plated Cu lead frame substrate with the first semiconductor chip to the third semiconductor chip mounted thereon was taken out from a stage of FC3000W, then placed in a dehydrator heated at 250 °C and then heated for 10 min to thereby cause the sinterable metal particles included in the adhesive sheet to be further sintered (i.e., subjected to the secondary sintering).

### (Measurement of shear strength)

The shear strength at 25 °C was measured in the same manner as in Example 1. The measurement result of the shear strength at 25 °C is shown in Table 2 below.

### [Example 3]

### (Production of a substrate with semiconductor chips)

An Ag-plated Cu lead frame substrate with semiconductor chips according to Example 3 in which three semiconductor chips are mounted on the Ag-plated Cu lead frame substrate with the adhesive sheet interposed therebetween was obtained by mounting the semiconductor chips on the Ag-plated Cu lead frame substrate in the same manner as in Example 2 except that the pressing and heating time was 10 sec.

### (Measurement of shear strength)

The shear strength at 25 °C was measured in the same manner as in Example 1. The measurement result of the shear strength at 25 °C is shown in Table 2 below.

### [Example 4]

### (Production of a substrate with semiconductor chips)

An Ag-plated Cu lead frame substrate with semiconductor chips according to Example 4 in which three semiconductor chips are mounted on the Ag-plated Cu lead frame substrate with the adhesive sheet interposed therebetween was obtained by mounting the semiconductor chips on the Ag-plated Cu lead frame substrate in the same manner as in Example 2 except that the pressing (applying a pressure) by the collet was performed at 20 MPa.

### (Measurement of shear strength)

The shear strength at 25 °C was measured in the same manner as in Example 1. The measurement result of the shear strength at 25 °C is shown in Table 2 below.

### [Example 5]

### (Production of a substrate with semiconductor chips)

An Ag-plated Cu lead frame substrate with semiconductor chips according to Example 5 in which three semiconductor chips are mounted on the Ag-plated Cu lead frame substrate with the adhesive sheet interposed therebetween was obtained by mounting the semiconductor chips on the Ag-plated Cu lead frame substrate in the same manner as in Example 1 except that the primary sintering was performed by heating the collet to 300 °C.

### (Measurement of shear strength)

The shear strength at 25 °C was measured in the same manner as in Example 1. The measurement result of the shear strength at 25 °C is shown in Table 2 below.

### [Example 6]

### (Production of a substrate with semiconductor chips)

An Ag-plated Cu lead frame substrate with semiconductor chips according to Example 6 in which three semiconductor chips were mounted on the Ag-plated Cu lead frame substrate with the adhesive sheet interposed therebetween was obtained by mounting the semiconductor chips on the Ag-plated Cu lead frame substrate in the same manner as in Example 1 except that the primary sintering was performed by heating the collet to 450 °C and the pressing and heating time was 5 sec.

### (Measurement of shear strength)

The shear strength at 25 °C was measured in the same manner as in Example 1. The measurement result of the shear strength at 25 °C is shown in Table 2 below.

### [Example 7]

### (Production of a substrate with semiconductor chips)

Three semiconductor chips with adhesive sheet configured in the same manner as in Example 1 were mounted on three die pads of a Pd-PPF (Palladium Pre Plated Lead Frame that is a Cu lead frame plated with Ni, Pd, and Au in this order. Thickness: 0.2 mm) to obtain a substrate with the semiconductor chips. The semiconductor chips with the adhesive sheet was mounted on the die pads of the Pd-PPF using, mainly, FC3000W manufactured by Toray Engineering Co., Ltd. Specifically, the mounting was performed in the following manner. The Pd-PPF was placed on a stage of FC3000W and not heated. That is, the temperature of the stage was 25 °C.
(1) The collet in the state where the semiconductor chip with the adhesive sheet (hereinafter referred to as the first semiconductor chip with the adhesive sheet) is mounted on the collet is heated to 100 °C.
(2) The collet heated at 100 °C is moved vertically downward to allow the adhesive sheet of the first semiconductor chip with the adhesive sheet to come into contact with the first die pad of the Pd-PPF.
(3) The collet is heated to 300 °C, while the first semiconductor chip with the adhesive sheet that is held in contact with the first die pad of the Pd-PPF is pressed, that is, applied with pressure by the collet, to thereby cause the sinterable metal particles in the adhesive sheet to be sintered, that is, to thereby subject the sinterable metal particles in the adhesive sheet to the primary sintering. Thereby, the first semiconductor chip with the adhesive sheet is mounted on the first die pad. The pressing (applying a pressure) by the collet is performed at 10 MPa. The pressing and heating time is 5 sec.
(4) The collet is pulled upward to be thereby separated from the first semiconductor chip with the adhesive sheet, and thereafter the temperature of the collet is lowered to a temperature at which the sinterable metal particles can be barely sintered (i.e., 50 °C).
(5) A second semiconductor chip with an adhesive sheet mounted on the collet is obtained using the collet in the same manner as the aforementioned method, and the collet is heated to 100 °C.
(6) In the same manner as in (2) and (3) described above, the second semiconductor chip with the adhesive sheet is mounted on a second die pad of the Pd-PPF.
(7) In the same manner as in (4) described above, the collet is pulled upward to be thereby separated from the second semiconductor chip with the adhesive sheet, and thereafter the temperature of the collet is lowered to a temperature at which the sinterable metal particles can be barely sintered (i.e., 50 °C).
(8) A third semiconductor chip with the adhesive sheet is mounted by the collet on a third die pad of the Pd-PPF in the same manner as described above.

In the manner mentioned above, the Pd-PPF with the adhesive sheet according to Example 1 in which three semiconductor chips are mounted on the Pd-PPF with the adhesive sheet interposed therebetween was obtained. The secondary sintering was not performed in Example 7.

### (Measurement of shear strength)

The shear strength at 25 °C was measured in the same manner as in Example 1. The measurement result of the shear strength at 25 °C is shown in Table 2 below.

### [Example 8]

### (Production of a substrate with semiconductor chips)

APd-PPF with semiconductor chips according to Example 8 in which three semiconductor chips are mounted on the Pd-PPF with the adhesive sheet interposed therebetween was obtained by mounting the semiconductor chips on the Pd-PPF in the same manner as in Example 7 except that the pressing (applying a pressure ) by the collet was performed at 5 MPa and the Pd-PPF (i.e., the Pd-PPF after the step (8) in Example 7 above) in which the first to third semiconductor chips are mounted thereon was taken out from a stage of FC3000W, then placed in a dehydrator heated at 300 °C, and then heated for 60 min to thereby cause the sinterable metal particles included in the adhesive sheet to be further sintered (i.e., subjected to the secondary sintering).

### (Measurement of shear strength)

The shear strength at 25 °C was measured in the same manner as in Example 1. The measurement result of the shear strength at 25 °C is shown in Table 2 below.

### [Example 9]

### (Production of a substrate with semiconductor chips)

APd-PPF with semiconductor chips according to Example 9 in which three semiconductor chips are mounted on the Pd-PPF with the adhesive sheet interposed therebetween was obtained by mounting the semiconductor chips on the Pd-PPF in the same manner as in Example 7 except that the stage of FC3000W was heated to 150 °C.

### (Measurement of shear strength)

The shear strength at 25 °C was measured in the same manner as in Example 1. The measurement result of the shear strength at 25 °C is shown in Table 2 below.

### [Example 10]

### (Production of a substrate with semiconductor chips)

APd-PPF with semiconductor chips according to Example 10 in which three semiconductor chips are mounted on the Pd-PPF with the adhesive sheet interposed therebetween was obtained by mounting the semiconductor chips on the Pd-PPF in the same manner as in Example 7 except that the primary sintering was performed by heating the collet to 400 °C.

### (Measurement of shear strength)

The shear strength at 25 °C was measured in the same manner as in Example 1. The measurement result of the shear strength at 25 °C is shown in Table 2 below.

### [Example 11]

### (Production of a substrate with semiconductor chips)

APd-PPF with semiconductor chips according to Example 11 in which three semiconductor chips are mounted on the Pd-PPF with the adhesive sheet interposed therebetween was obtained by mounting the semiconductor chips on the Pd-PPF in the same manner as in Example 10 except that the Pd-PPF (i.e., the Pd-PPF after the step (8) in Example 7 above) with the first to third semiconductor chips mounted thereon was taken out from a stage of FC3000W, then placed in a dehydrator heated at 300 °C and heated for 60 min to thereby cause the sinterable metal particles included in the adhesive sheet to be further sintered (i.e., subjected to the secondary sintering).

### (Measurement of shear strength)

The shear strength at 25 °C was measured in the same manner as in Example 1. The measurement result of the shear strength at 25 °C is shown in Table 2 below.

### Example 12

### <Laminate>

A mixture of materials having the respective mass ratios shown in Table 1 below was stirred and mixed using a hybrid mixer (product name: "HM-500" manufactured by KEYENCE CORPORATION) in the "stirring mode" to prepare a varnish. The stirring and mixing using the hybrid mixer was performed by three steps. Specifically, first, a primary mixture including thermosetting resins and a thermoplastic resin that is a high molecular binder was stirred and mixed for three minutes (i.e., primary stirring), then a secondary mixture obtained by adding conductive particles and a volatile agent that is a low molecular binder to the primary mixture was stirred and mixed for 6 minutes (i.e., secondary stirring), and then a tertiary mixture obtained by adding a catalyst and a solvent to the secondary mixture was further stirred and mixed for 3minutes (i.e., tertiary stirring). The varnish was applied to one side of a release treatment film (product name: "MRA38", with a thickness of 38 µm, manufactured by Mitsubishi Chemical Corporation), followed by drying at 100 °C for 2 minutes to form an adhesive layer (i.e., adhesive sheet) having a thickness of 30 µm to obtain a laminate. The materials shown in Table 1 below are as follows:
- Phenol resin
   MEHC-7851S (bisphenol type phenol resin, phenol equivalent of 209 g/eq), manufactured by MEIWA PLASTIC INDUSTRIES, LTD.
- Solid epoxy resin
   KI-3000-4 (cresol novolak type multifunctional epoxy resin, epoxy equivalent of 200 g/eq), manufactured by Nippon Steel & Sumikin Chemical Co., Ltd.
- Liquid epoxy resin
   EXA-4816 (aliphatic modified bisphenol A type epoxy resin (difunctional type), epoxy equivalent of 403 g/eq), manufactured by DIC Corporation
- Silver (Ag)-coated copper (Cu) particles
   Product name AOP-TCY-16 (EN) manufactured by DOWA Electronics Materials Co., Ltd.; spherical copper particles coated with 20 mass% of silver particles; particle shape: a spherical shape; and a volume average particle size D₅₀ of 2.8 µm)
- Silver (Ag) particles
   Product name AG-2-47J manufactured by DOWA Electronics Materials Co., Ltd. (silver particles subjected to surface treatment; particle shape: a spherical shape; and a volume average particle size D₅₀ of 0.5 µm)
- Volatile agent (isobornyl cyclohexanol (MTPH))
   MTPH manufactured by NIPPON TERPENE CHEMICALS, INC.
- Acrylic resin
   TEISANRESIN SG-70L (including MEK and toluene as solvents, solid content of 12.5 mass%, glass transition temperature of -13 °C, mass-average molecular weight of 900,000, acid value of 5 mg/KOH, carboxyl group-containing acrylic copolymer), manufactured by Nagase ChemteX Corporation
- Coupling agent
   KBE-846 (bis(triethoxysilylpropyl)tetrasulfide) manufactured by Shin-Etsu Chemical Co., Ltd.
- Catalyst
   TPP-MK (Tetraphenylphosphonium tetra-p-tolylborate), manufactured by HOKKO CHEMICAL INDUSTRY CO., LTD.
- Solvent
   Methyl ethyl ketone (MEK)

**Table 1**

| | | Product name | mass% (parts by mass) | mass% (parts by mass) |
|---|---|---|---|---|
| Metal particles | Ag-coated Cu particles | AOP-TCY-16(EN) | 28.3 | 94.3 |
| | Ag particles | AG-2-47J | 66.0 | |
| Thermosetting resin | Liquid epoxy resin | EXA-4816 | 0.04 | 5.66 |
| | Solid epoxy resin | KI-3000-4 | 0.25 | |
| | Phenol resin | MEHC-7851S | 0.30 | |
| Thermoplastic resin (High molecular binder) | Acrylic resin solution | SG-70L | 4.73 | |
| Volatile component (Low molecular binder) | Isobornyl cyclohexanol | MTPH | 0.29 | |
| Coupling agent | Bis(triethoxysilylpropyl)tetrasulfide | KBE-846 | 0.045 | |
| Catalyst | Tetraphenylphosphonium tetra-p-tolylborate | TPP-MK | 0.003 | |
| Solvent | Methyl ethyl ketone | MEK | Appropriate amount | Appropriate amount |

### (Production of a semiconductor chip with an adhesive sheet)

A semiconductor chip with an adhesive sheet was produced in the same manner as in Example 1 except that the adhesive sheet configured as described above was used.

### (Production of a substrate with semiconductor chips)

APd-PPF with semiconductor chips according to Example 12 in which three semiconductor chips are mounted on the Pd-PPF with the adhesive sheet interposed therebetween was obtained by mounting the semiconductor chips on the Pd-PPF in the same manner as in Example 10 except that the pressing (applying a pressure) by the collet was performed at 3 MPa.

### (Measurement of shear strength)

The shear strength at 25 °C was measured in the same manner as in Example 1. The measurement result of the shear strength at 25 °C is shown in Table 2 below.

### [Example 13]

### <Laminate>

A laminate including an adhesive layer (i.e., adhesive sheet) having a thickness of 30 µm formed on one side of a release treatment film (product name: "MRA38", with a thickness of 38 µm, manufactured by Mitsubishi Chemical Corporation) was obtained in the same manner as in Example 12.

### (Production of a semiconductor chip with an adhesive sheet)

A semiconductor chip with an adhesive sheet was produced in the same manner as in Example 1 except that the adhesive sheet configured as described above was used.

### (Production of a substrate with semiconductor chips)

APd-PPF with semiconductor chips according to Example 13 in which three semiconductor chips are mounted on the Pd-PPF with the adhesive sheet interposed therebetween was obtained by mounting the three semiconductor chips on the Pd-PPF in the same manner as in Example 8 except that the primary sintering was performed by, using the adhesive sheet configured as described above, heating the collet to 400 °C, and the pressing (applying a pressure) by the collet was performed at 3 MPa.

### (Measurement of shear strength)

The shear strength at 25 °C was measured in the same manner as in Example 1. The measurement result of the shear strength at 25 °C is shown in Table 2 below.

### [Example 14]

### <Laminate>

A laminate including an adhesive layer (i.e., adhesive sheet) having a thickness of 30 µm formed on one side of a release treatment film (product name: "MRA38", with a thickness of 38 µm, manufactured by Mitsubishi Chemical Corporation) was obtained in the same manner as in Example 12.

### (Production of a semiconductor chip with an adhesive sheet)

A semiconductor chip with an adhesive sheet was produced in the same manner as in Example 1 except that the adhesive sheet configured as described above was used.

### (Production of a substrate with semiconductor chips)

APd-PPF with semiconductor chips according to Example 14 in which three semiconductor chips are mounted on the Pd-PPF with the adhesive sheet interposed therebetween was obtained by mounting the three semiconductor chips on the Pd-PPF in the same manner as in Example 12 except that the temperature of the stage of FC3000W was heated to 150 °C.

### (Measurement of shear strength)

The shear strength at 25 °C was measured in the same manner as in Example 1. The measurement result of the shear strength at 25 °C is shown in Table 2 below.

### [Comparative Example 1]

### (Production of a substrate with semiconductor chips)

A substrate with semiconductor chips was produced in the following manner. First, three semiconductor chips with adhesive sheet were temporarily fixed respectively to three die pads of an Ag-plated Cu lead frame substrate. The adhesive sheet described in the section of Example 1 was used. The semiconductor chips with the adhesive sheet were temporarily fixed to the die pads of the Ag-plated Cu lead frame substrate using FC3000W manufactured by Toray Engineering Co., Ltd. Specifically, the temporal fixing was performed in the following manner. The Ag-plated Cu lead frame substrate was placed on the stage of FC3000W.
(1) The collet in the state where a semiconductor chip with an adhesive sheet (hereinafter referred to as the first semiconductor chip with the adhesive sheet) is mounted on the collet is heated to 50 °C.
(2) The first semiconductor chip with the adhesive sheet is mounted on the first die pad, while pressing, that is, applying a pressure the first semiconductor chip with the adhesive sheet onto the first die pad of the Ag-plated Cu lead frame substrate from the adhesive sheet side by the collet. Pressing or applying a pressure by the collet is performed at 0.01 MPa. The pressing time is 1 sec.
(3) The collet is pulled upward to be thereby separated from the first semiconductor chip with the adhesive sheet.
(4) A second semiconductor chip with an adhesive sheet in the state being mounted on the collet is obtained using the collet in the same manner as the aforementioned method, and then the second semiconductor chip with the adhesive sheet is mounted on a second die pad of the Ag-plated Cu lead frame substrate in the same manner as in (2) described above. The collet is pulled upward after the second semiconductor chip with the adhesive sheet is mounted on the second die pad of the Ag-plated Cu lead frame substrate to be thereby separated from the second semiconductor chip with the adhesive sheet.
(5) A third semiconductor chip with an adhesive sheet in the state of being mounted on the collet is obtained using the collet in the same manner as the aforementioned method, and then the third semiconductor chip with the adhesive sheet is mounted on a third die pad of the Ag-plated Cu lead frame substrate in the same manner as in (2) described above. The collet is pulled upward after the third semiconductor chip with the adhesive sheet is mounted on the third die pad of the Ag-plated Cu lead frame substrate to be thereby separated from the third semiconductor chip with the adhesive sheet.

In the aforementioned manner, the semiconductor chips with the adhesive sheet were temporarily fixed to the Ag-plated Cu lead frame substrate. Next, the semiconductor chips with the adhesive sheet were mounted on the Ag-plated Cu lead frame substrate. That is, the semiconductor chips with the adhesive sheet were fixed to the Ag-plated Cu lead frame substrate. The semiconductor chips with the adhesive sheet were mounted on (fixed to) the Ag-plated Cu lead frame substrate using the HTM-3000 manufactured by Hakuto. Specifically, the mounting was performed in the following manner. The Ag-plated Cu lead frame substrate to which the semiconductor chips with the adhesive sheet was temporarily fixed was placed on a stage of HTM-3000.
(1') The temperature of the stage is raised to 200 °C, while pressing parallel plates the first to third semiconductor chips with the adhesive sheets from above and below of the stage, that is, while pressing them by the parallel plates, to thereby cause the sinterable metal particles in the adhesive sheet to be sintered, that is, to thereby subject the sinterable metal particles in the adhesive sheet to the primary sintering. Thereby, the first to third semiconductor chips with the adhesive sheets are mounted on the Ag-plated Cu lead frame. That is, the first to third semiconductor chips with the adhesive sheets are fixed to the Ag-plated Cu lead frame. The pressing (applying a pressure) by the parallel plates is performed at 10 MPa. The pressing and heating time is 50 sec.

In this manner, the Ag-plated Cu lead frame substrate with the adhesive sheet according to Comparative Example 1 in which three semiconductor chips are mounted on the Ag-plated Cu lead frame substrate with the adhesive sheet interposed therebetween was obtained.

### (Measurement of shear strength)

The shear strength at 25 °C was measured in the same manner as in Example 1. The measurement result of the shear strength at 25 °C is shown in Table 2 below.

### [Comparative Example 2]

### (Production of a substrate with semiconductor chips)

A substrate with semiconductor chips of Comparative Example 2 was produced in the same manner as in Comparative Example 1 except that the Ag-plated Cu lead frame substrate with the first to third semiconductor chips mounted thereon (fixed thereto) was taken out from the stage of HTM-3000 by, after the step (1') above was performed, releasing the Ag-plated Cu lead frame substrate from the pressed state by the parallel plates, that is, bringing it into non-pressed state, then placing it in a dehydrator heated at 250 °C and heated for 10 min to thereby cause the sinterable metal particles included in the adhesive sheet to be further sintered (i.e., subjected to the secondary sintering). Thus, an Ag-plated Cu lead frame substrate with semiconductor chips according to Comparative Example 2 in which three semiconductor chips are mounted on the Ag-plated Cu lead frame substrate with the adhesive sheet interposed therebetween was obtained.

### (Measurement of shear strength)

The shear strength at 25 °C was measured in the same manner as in Example 1. The measurement result of the shear strength at 25 °C is shown in Table 2 below.

### [Comparative Example 3]

### (Production of a substrate with semiconductor chips)

A substrate with semiconductor chips of Comparative Example 3 was produced in the same manner as in Comparative Example 1 except that the temperature of the stage of HTM-3000 was changed to 300 °C when the semiconductor chips with the adhesive sheets were mounted on (fixed to) the Ag-plated Cu lead frame substrate. Thus, the Ag-plated Cu lead frame substrate according to Comparative Example 3 in which the three semiconductor chips are mounted on the Ag-plated Cu lead frame substrate with the adhesive sheet interposed therebetween.

### (Measurement of shear strength)

The shear strength at 25 °C was measured in the same manner as in Example 1. The measurement result of the shear strength at 25 °C is shown in Table 2 below.

A standard deviation of each of the shear strength at 25 °C and the shear strength at 250 °C was calculated for each of Examples and Comparative Examples. The standard deviations were also shown in Table 2 below.

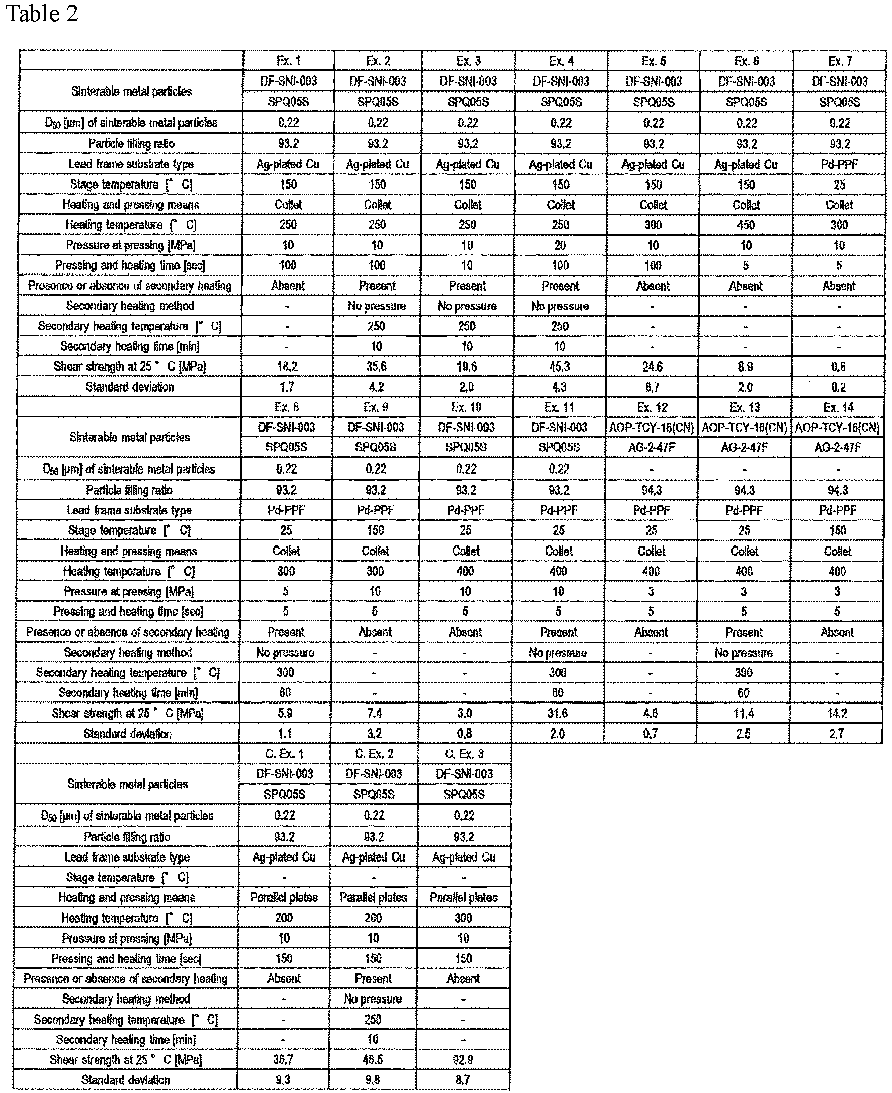

It can be seen from Table 2 that a standard deviation of the shear strength at 25 °C in each of Examples 1 to 14 is 7 or less, and thus there are relatively small fluctuations in uneven adhesion among the three semiconductor chips mounted on the substrate with the adhesive sheet interposed therebetween. In contrast, it can be seen that a standard deviation of the shear strength at 25 °C in each of Comparative Examples 1 to 3 is 8 or more, and thus there are relatively large fluctuations in uneven adhesion among the three semiconductor chips mounted on the substrate with the adhesive sheet interposed therebetween.

### REFERENCE SIGNS LIST

- 1:: Substrate sheet
- 2.: Adhesive sheet
- 10:: Laminate
- A:: Collet
- B1:: First semiconductor chip
- B2:: Second semiconductor chip
- C:: Dicing tape
- D:: Lead frame substrate
- E1:: First die pad
- E2:: Second die pad
- F:: Heating and pressing equipment
- G:: Stage
- H:: Stage

## Claims

1. A method for producing a semiconductor device, the method comprising:
a semiconductor chip-mounting step of subsequently pressing a plurality of semiconductor chips by a first pressing member to respectively bond the plurality of semiconductor chips to a plurality of mounting areas provided on a substrate, wherein
the bonding is performed in a state where adhesive sheets are respectively interposed between the plurality of semiconductor chips and the plurality of mounting areas,
each of the adhesive sheets comprises sinterable metal particles that can be sintered by heating at a temperature of 400 °C or less, and
the first pressing member is heated to a temperature at which the sinterable metal particles can be sintered.

2. The method for producing the semiconductor device according to claim 1, further comprising:
performing, after the semiconductor chip-mounting step, a secondary heating step of heating the substrate with the plurality of semiconductor chips mounted thereon to a temperature, at which the sinterable metal particles can be sintered, wherein
in the secondary heating step, the aforementioned heating is performed while not pressing part or all of the plurality of semiconductor chips onto the substrate.

3. The method for producing the semiconductor device according to claim 2, wherein in the secondary heating step, the aforementioned heating is performed while not pressing all of the plurality of semiconductor chips onto the substrate.

4. The method for producing the semiconductor device according to claim 1, further comprising:
performing, after the semiconductor chip-mounting step, a secondary heating step of heating the substrate with the plurality of semiconductor chips mounted thereon to a temperature, at which the sinterable metal particles can be sintered, wherein
in the secondary heating step, the aforementioned heating is performed while pressing part or all of the plurality of semiconductor chips onto the substrate.

5. The method for producing the semiconductor device according to claim 4, wherein in the secondary heating step, the aforementioned heating is performed while pressing all of the plurality of semiconductor chips onto the substrate.

6. The method for producing the semiconductor device according to any one of claims 1 to 5, wherein in the semiconductor chip-mounting step, the first pressing member is heated to a temperature of 250 °C or more.

7. A semiconductor device produced by the method for producing the semiconductor device according to any one of claims 1 to 6, wherein
a shear strength between one of the plurality of semiconductor chips and a corresponding one of the plurality of mounting areas at 25 °C is 2 MPa or more.
